Europäisches Patentamt

European Patent Office

Office européen des brevets

(11) Veröffentlichungsnummer: **0 323 871**
**A2**

# (12) EUROPÄISCHE PATENTANMELDUNG

(21) Anmeldenummer: **89200013.4**

(22) Anmeldetag: **04.01.89**

(51) Int. Cl.⁴: **H 03 K 7/06**
G 01 D 5/248, H 04 B 9/00

(30) Priorität: **08.01.88 DE 3800265**

(43) Veröffentlichungstag der Anmeldung:
**12.07.89 Patentblatt 89/28**

(84) Benannte Vertragsstaaten: **DE FR GB IT**

(71) Anmelder: **Philips Patentverwaltung GmbH**
**Wendenstrasse 35 Postfach 10 51 49**
**D-2000 Hamburg 1 (DE)**

(84) Benannte Vertragsstaaten: **DE**

(71) Anmelder: **N.V. Philips' Gloeilampenfabrieken**
**Groenewoudseweg 1**
**NL-5621 BA Eindhoven (NL)**

(84) Benannte Vertragsstaaten: **FR GB IT**

(72) Erfinder: **Kordts, Jürgen**
**Schinkelring 63a**
**D-2000 Norderstedt (DE)**

**Finck, Gerald**
**Am Mühlenteich 83**
**D-2407 Bad Schwartau (DE)**

(74) Vertreter: **Auer, Horst, Dipl.-Ing. et al**
**Philips Patentverwaltung GmbH Wendenstrasse 35**
**Postfach 10 51 49**
**D-2000 Hamburg 1 (DE)**

(54) Spannungs-Frequenz-Umsetzer und seiner Verwendung in einer Lichtwellenleiter-Uebertragungsanordnung.

(57) Die Erfindung bezieht sich auf einen Spannungs-Frequenz-Umsetzer, der einen ersten und zweiten Umschalter (13, 20) enthält. Der erste Umschalter führt in seiner ersten Stellung eine Meßspannung und in seiner zweiten Stellung eine Referenzspannung einem ersten Eingang (15) einer Vergleichsschaltung (16) zu. Der zweite Umschalter führt in seiner ersten Stellung ein erstes zu integrierendes Signal und in seiner zweiten Stellung ein zweites zu integrierendes Signal über einen Integrator (22, 34) dem zweiten Eingang der Vergleichsschaltung zu. Die Vergleichsschaltung erzeugt von der Meßspannung abhängige Impulse und setzt die beiden Umschalter in ihre erste Stellung, wenn die vom Integrator gelieferte Spannung gleich der Referenzspannung ist, und in ihre zweite Stellung, wenn der vom Integrator gelieferte Wert gleich der Meßspannung ist. Eines der zu integrierenden Signale ist dabei aus der Meßspannung abgeleitet.

FIG.1

EP 0 323 871 A2

**Beschreibung**

### Spannungs-Frequenz-Umsetzer und seine Verwendung in einer Lichtwellenleiter-Übertragungsanordnung

Die Erfindung bezieht sich auf einen Spannungs-Frequenz-Umsetzer mit einem ersten Umschalter, der in seiner ersten Stellung eine Meßspannung und in seiner zweiten Stellung eine Referenzspannung einem ersten Eingang einer Vergleichsschaltung zuführt, und mit einem zweiten Umschalter, der in seiner ersten Stellung ein erstes zu integrierendes Signal und in seiner zweiten Stellung ein zweites zu integrierendes Signal über einen Integrator dem zweiten Eingang der Vergleichsschaltung zuführt, welche von der Meßspannung abhängige Impulse erzeugt und welche die beiden Umschalter in ihre erste Stellung setzt, wenn die vom Integrator gelieferte Spannung gleich der Referenzspannung ist, und in ihre zweite Stellung setzt, wenn der vom Integrator gelieferte Wert gleich der Meßspannung ist.

Ein derartiger Spannungs-Frequenz-Umsetzer setzt eine analoge Spannung in Rechteckschwingungen (Rechteckimpulse) um, deren Frequenz umgekehrt proportional der Amplitude der angelegten Spannung ist. Auf einen Rechteckimpuls, der eine konstante Amplitude aufweist, folgt eine Impulspause. Die Dauer des Impulses und der Impulspause ist als Periodendauer definiert, die dem reziproken Wert der Frequenz entspricht.

Der eingangs erwähnte Spannungs-Frequenz-Umsetzer ist aus der DE-AS 21 35 802 bekannt. Einem ersten Eingang einer Vergleichsschaltung wird hierbei von einem ersten Umschalter eine Meßspannung oder eine Referenzspannung zugeführt. Ein Ausgang eines Integrators ist an den zweiten Eingang der Vergleichschaltung gelegt. Dem Eingang des Integrators wird von einem zweiten Umschalter eine erste oder eine zweite zu integrierende Spannung zugeführt. Die beiden zu integrierenden Spannungen weisen eine umgekehrte Polarität auf. In der ersten Stellung des ersten Umschalters wird die Meßspannung an den ersten Eingang der Vergleichsschaltung und in der ersten Stellung des zweiten Umschalters die erste zu integrierende Spannung an den Integrator geschaltet. Die Vergleichsschaltung erzeugt einen positiven Impuls, falls die integrierte Spannung gleich der Meßspannung wird. Hierdurch wird ein Umschalten der beiden Umschalter in ihre zweite Stellung bewirkt. In der zweiten Stellung des ersten Umschalters liegt die Referenzspannung, die kleiner ist als die Meßspannung, am ersten Eingang der Vergleichsschaltung und in der zweiten Stellung des zweiten Umschalters die zweite zu integrierende Spannung am Integrator. Erreicht die Ausgangsspannung des Integrators die Referenzspannung, ist der von der Vergleichsschaltung erzeugte Impuls beendet und die Umschalter werden wieder in ihre erste Stellung gesetzt.

Die Periodendauer der Impulse, die von einem solchen Spannungs-Frequenz-Umsetzer erzeugt werden, geht gegen Null, falls die Referenzspannung gleich dem Massepotential ist und die Meßspannung immer kleiner wird. Das bedeutet, daß die Periodendauer einen sehr großen Variationsbereich hat und keine Möglichkeit besteht, die zeitliche Dauer zwischen zwei Rechteckimpulsen bei sehr geringer Meßspannung zu bestimmen.

Der Erfindung liegt daher die Aufgabe zugrunde, einen Spannungs-Frequenz-Umsetzer zu schaffen, bei dem die zeitliche Dauer zwischen zwei Rechteckimpulsen bei sehr geringer Meßspannung bestimmt werden kann.

Diese Aufgabe wird bei einem Spannungs-Frequenz-Umsetzer der eingangs genannten Art dadurch gelöst, daß eines der zu integrierenden Signale aus der Meßspannung abgeleitet ist.

Bei dem erfindungsgemäßen Spannungs-Frequenz-Umsetzer wird die Meßspannung nicht nur dem ersten, sondern auch dem zweiten Umschalter zugeführt. Eines der zu integrierenden Signale wird aus der Meßspannung abgeleitet. Hierbei muß darauf geachtet werden, daß das aus der Meßspannung abgeleitete zu integrierende Signal die entgegengesetzte Polarität zum anderen zu integrierenden Signal aufweist. Falls das erste zu integrierende Signal negativ und das zweite zu integrierende Signal positiv ist, muß die Meßspannung immer größer als die Referenzspannung sein. Wenn das erste zu integrierende Signal positiv und das zweite zu integrierende Signal negativ ist, muß die Meßspannung immer kleiner als die Referenzspannung sein. Das aus der Meßspannung abgeleitete integrierte Signal darf nicht Null werden, da der Integrator dann einen konstanten Wert am Ausgang abgibt und eine Impulserzeugung nicht mehr möglich ist. Durch die erfindungsgemäße Maßnahme ist die Periodendauer der Impulse bei sehr geringer Meßspannung im wesentlichen durch die Integrationskonstante festgelegt.

Mit Hilfe des Spannungs-Frequenz-Umsetzers kann auch das Verhältnis zweier Meßsignale gebildet werden. Außer dem ersten Umschalter kann auch dem zweiten Umschalter ein weiteres Meßsignal zugeführt werden. Die Frequenz der Rechteckimpulse entspricht dann dem Verhältnis zwischen den Meßsignalen.

In einer ersten Weiterbildung der Erfindung ist vorgesehen, daß die Referenzspannung gleich dem Massepotential, das erste zu integrierende Signal gleich der invertierten Meßspannung und das zweite zu integrierende Signal gleich einer positiven Bezugsspannung ist. Bei dieser Weiterbildung ist unter der Voraussetzung, daß die Meßspannung gegen Null geht, die kleinste Periodendauer zwischen zwei Impulsen durch die Integrationskonstante bestimmt. Der Integrator erzeugt hierbei eine invertierte integrierte Spannung.

Bei einer anderen Weiterbildung der Erfindung ist vorgesehen, daß das erste zu integrierende Signal gleich einem negativen Bezugstrom ist und daß ein Spannungs-Strom-Umsetzer die Meßspannung in einen Meßstrom umsetzt, der gleich dem zweiten zu integrierenden Signal ist. Hierbei wird mittels eines Spannungs-Strom-Umsetzers die Meßspannung in einen Strom umgesetzt, der in der zweiten Stellung des zweiten Umschalters dem invertierenden Integrator zugeführt wird. In der ersten Stellung des zweiten Umschalters wird ein negativer z.B. konstanter Bezugsstrom dem Integrator zugeleitet. Mit Hilfe dieser Weiterbildung ist es möglich, das Verhältnis zweier Meßströme zu bilden. Die Meßspannung wird dabei mittels eines Strom-Spannungs-Umsetzers aus einem ersten Meßstrom gebildet. Der andere Meßstrom wird als Bezugsstrom dem zweiten Umschalter zugeleitet. Die Referenzspannung kann auch bei diesem Umsetzer gleich dem Massepotential sein. Bei Betreiben des Umsetzers mit einer Versorgungsspannung bildet das Massepotential eine Aussteuerungsgrenze der Signale. Ein Setzen der Referenzspannung auf Massepotential könnte zu Fehlern führen. Daher wird vorzugsweise die Referenzspannung aus der Meßspannung abgeleitet. Die Spannung am Eingang des ersten Umschalters, der in der zweiten Stellung mit seinem Ausgang verbunden ist, kann daher niemals gleich dem Massepotential werden.

Die Erfindung bezieht sich ferner auf die Verwendung eines Spannungs-Frequenz-Umsetzers in einer Anordnung zur Übertragung eines Meßsignals eines optischen Sensors über einen Lichtwellenleiter, bei der ein optisches Meßsignal in einem optisch-elektronischen-Umsetzer in einen Strom und in einem nachgeordneten Strom-Spannungs-Umsetzer der Strom in die Meßspannung umgesetzt wird und bei der die von dem Spannungs-Frequenz-Umsetzer gelieferten Impulse in einem Differenzierglied differenziert und die differenzierten Impulse mittels eines elektronisch-optischen-Umsetzers in ein optisches Signal umgesetzt werden, welches in den Lichtwellenleiter eingestrahlt wird.

Optische Sensoren verändern üblicherweise die Lichtintensität eines ihnen zugeführten Lichtsendesignals in Abhängigkeit von der zu erfassenden Meßgröße. Bei der Übertragung dieser analogen optischen Sensor-Meßsignale über einen Lichtwellenleiter kann das optische Meßsignal durch die Dämpfung des Lichtwellenleiters verändert werden. Bei der oben genannten Verwendung wird das optische Meßsignal, das von einem Sensor geliefert wird, mittels eines optisch-elektronischen-Umsetzers in einen elektrischen Meßstrom umgesetzt und dem Spannungs-Frequenz-Umsetzer zugeführt, welcher aus dem Meßstrom elektrische Impulse erzeugt, deren Frequenz umgekehrt proportional der Amplitude des analogen optischen Meßsignals ist. Diese Impulse werden differenziert und über einen elektronisch-optischen-Umsetzer in einen Lichtwellenleiter eingestrahlt. Die Dämpfung der eingestrahlten optischen differenzierten Impulse in einen Lichtwellenleiter wirkt sich auf das Meßsignal nicht aus, da nicht die Amplitude eines Impulses sondern die Periodendauer der Impulse abhängig von der Meßgröße ist.

Des weiteren bezieht sich die Erfindung auf die Verwendung eines Spannungs-Frequenz-Umsetzers in einer Anordnung zur Übertragung zweier optischer Meßsignale wenigstens eines optischen Sensors über einen Lichtwellenleiter, bei der ein erstes optisches Meßsignal in einem ersten optisch-elektronischen-Umsetzer in einen Strom und in einem nachgeordneten Strom-Spannungs-Umsetzer der Strom in die Meßspannung und ein zweites optisches Meßsignal in einem zweiten optisch-elektronischen-Umsetzer in den Bezugsstrom umgesetzt wird, der das erste zu integrierende Signal bildet, und bei der die von dem Spannungs-Frequenz-Umsetzer gelieferten Impulse in einem Differenzierglied differenziert und die differenzierten Impulse mittels eines elektronisch-optischen-Umsetzers in ein optisches Signal umgesetzt werden, welches in den Lichtwellenleiter eingestrahlt wird.

Das von einem optischen Sensor erzeugte optische Meßsignal schwankt häufig wegen der Instabilität des dem Sensor zugeführten Sendelichts. Die obige Verwendung ermöglicht es, das Meßsignal unabhängig von der Instabilität des Sendelichts zu übertragen. Hierbei wird das Sensorsignal als erstes optisches Meßsignal über einen ersten optisch-elektronischen-Umsetzer und einen nachgeordneten Strom-Spannungs-Umsetzer in den Spannungs-Frequenz-Umsetzer eingespeist. Das Sendelicht wird als zweites optisches Meßsignal in einem zweiten optisch-elektronischen-Umsetzer in einen Bezugsstrom umgesetzt, der dem zweiten Umschalter zugeführt wird. Im Spannungs-Frequenz-Umsetzer wird das Verhältnis der beiden Meßsignale gebildet, wodurch eine Unabhängigkeit von der Instabilität des Sendelichts erreicht wird. Das Signal, welches dem Verhältnis der beiden Meßsignale entspricht, wird in optische Impulse umgesetzt, deren Periodendauer der Amplitude des Signals entspricht.

Ausführungsbeispiele der Erfindung werden nachstehend anhand der Zeichnungen näher erläutert. Es zeigen:

Fig. 1 ein erstes Blockschaltbild einer Anordnung zur Übertragung eines Meßsignals eines optischen Sensors über einen Lichtwellenleiter mit einem Spannungs-Frequenz-Umsetzer,

Fig. 2 schematisch skizzierte Signale, die in der Anordnung nach Fig. 1 auftreten,

Fig. 3 ein zweites Blockschaltbild einer Anordnung zur Übertragung eines Meßsignals eines optischen Sensors über einen Lichtwellenleiter mit einem Spannungs-Frequenz-Umsetzer und

Fig. 4 ein etwas detaillierteres Ausführungsbeispiel der Anordnung nach Fig. 3.

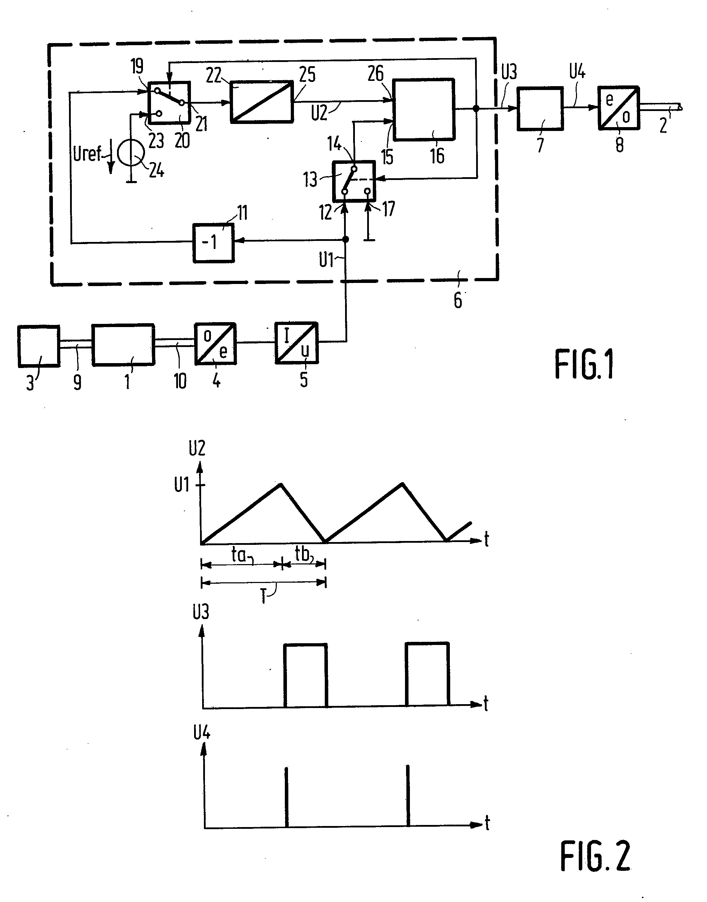

Die in Fig. 1 dargestellte Anordnung zur Übertragung eines Meßsignals eines optischen Sensors 1 über einen Lichtwellenleiter 2 enthält eine Sendelichtquelle 3, einen optisch-elektronischen-Umsetzer 4, einen Strom-Spannungs-Umsetzer 5, einen Spannungs-Frequenz-Umsetzer 6, einen Differenzierer 7 und einen elektronisch-optischen-Umsetzer 8. Die Sendelichtquelle 3 erzeugt ein Sendelicht, das über einen kurzen Lichtleiter 9 einem optischen Sensor 1, z.B. einem Drucksensor, zugeführt wird. Die Meßgröße (Druck) bewirkt eine Veränderung der Intensität des Sendelichts. Das von der Meßgröße beeinflußte Sendelicht wird als optisches Meßsignal über einen Lichtleiter 10 dem optisch-elektronischen-Umsetzer 4 zugeleitet. Der Umsetzer 4 erzeugt einen dem optischen Meßsignal entsprechenden elektrischen Strom, der in dem Strom-Spannungs-Umsetzer 5 in eine elektrische Meßspannung U1 umgesetzt wird. Im nachgeschalteten Spannungs-Frequenz-Umsetzer 6 wird aus dieser Meßspannung eine Folge von Impulsen erzeugt, deren Frequenz umgekehrt proportional der analogen Meßspannung U1 ist.

Hierfür wird die Meßspannung U1 dem ersten Eingang 12 eines ersten Umschalters 13 zugeleitet, der Teil des Spannungs-Frequenz-Umsetzers 6 ist und dessen Ausgang 14 mit dem ersten Eingang 15 einer Vergleichsschaltung 16 verbunden ist. Der zweite Eingang 17 des Umschalters 13 liegt an einem Massepotential. Die Meßspannung U1 wird über einen Inverter 11 auch dem ersten Eingang 19 eines zweiten Umschalters 20 zugeleitet, dessen Ausgang 21 mit einem invertierenden Integrator 22 verbunden ist. Der zweite Eingang 23 des Umschalters 20 ist mit einer Referenzspannungsquelle 24 verbunden. Der Ausgang 25 des Integrators 22 ist mit dem zweiten Eingang 26 der Vergleichsschaltung 16 verbunden. Gesteuert werden die beiden Umschalter 13 und 20 durch die Vergleichsschaltung 16.

Die Ausgangsspannung U3 der Vergleichsschaltung 16 oder des Spannungs-Frequenz-Umsetzers 6 weist zwei Spannungszustände auf. Ein niedriger Spannungszustand liegt vor, wenn die Spannung am ersten Eingang 15 größer als die Spannung am zweiten Eingang 26 ist. Wird die ursprünglich kleinere Spannung am zweiten Eingang 26 der Vergleichsschaltung 16 gleich der Spannung am ersten Eingang 15, wird die Ausgangsspannung der Vergleichsschaltung 16 in einen höheren Spannungszustand gesetzt. Der höhere Spannungszustand liegt dann vor, wenn die Spannung am zweiten Eingang 26 größer ist als die Spannung am ersten Eingang 15 der Vergleichsschaltung 16. Die Ausgangsspannung U3 der Vergleichsschaltung 16, welche die Steuerspannung für die Umschalter 13 und 20 ist, bewirkt, daß die Schalter von der ersten in die zweite Stellung gehen, wenn die Ausgangsspannung der Vergleichsschaltung 16 von einem niedrigen auf einen hohen Spannungszustand wechselt. Von der zweiten in die erste Stellung wird zurückgeschaltet, wenn die Ausgangsspannung der Vergleichsschaltung 16 von einem hohen auf einen niedrigen Spannungszustand zurückkehrt. Die erste Stellung des Umschalters 13 liegt vor, wenn dessen Ausgang 14 und dessen Eingang 12 verbunden ist. Der Ausgang 21 ist in der ersten Stellung des Umschalters 20 mit seinem Eingang 19 verbunden.

Sind die beiden Umschalter 13 und 20 von ihrer zweiten in ihre erste Stellung zurückgekehrt, integriert der Integrator 20 die invertierte Meßspannung U1. Die Spannung U2 am Ausgang 25 des Integrators ist also gleich:

$$U2 = K \ U1 \ t, \qquad (1)$$

wobei K die Integrationskonstante des Integrators 22 und t die Zeit ist. Wird die Ausgangsspannung U2 des Integrators 25 gleich der Spannung U1 am ersten Eingang 15 der Vergleichsschaltung 16, schaltet die Vergleichsschaltung 16 die beiden Umschalter 13 und 20 in ihre zweite Stellung. Die Zeit ta, in der die beiden Umschalter 13 und 20 in ihrer ersten Stellung sind, ist durch die folgende Gleichung gegeben:

$$ta = 1/K. \qquad (2)$$

Die Ausgangsspannung U2 des Integrators 22 in der zweiten Stellung der beiden Umschalter 13 und 20 ist durch die folgende Gleichung gegeben:

$$U2 = U1 - K \ Uref \ t, \qquad (3)$$

wobei die Spannung Uref die Spannung der Referenzspannungsquelle 24 ist. Die Zeit tb beginnt nach dem Umschalten von der ersten in die zweite Stellung und endet, wenn die Spannung U2 am zweiten Eingang 26 der Vergleichsschaltung 16 das Massepotential erreicht hat, d.h. Null ist. Für die Zeit tb ergibt sich:

$$tb = U1/(K \ Uref). \qquad (4)$$

Die Periodendauer T setzt sich aus der Summe der beiden Zeiten ta und tb zusammen. Dafür ergibt sich:

$$T = (1 + U1/Uref)/K. \qquad (5)$$

Wie man aus der Gleichung (5) entnehmen kann, ist die Periodendauer $T \approx 1/K$, wenn die Meßspannung U1 immer kleiner wird. Die Meßspannung U1 darf jedoch niemals gleich Null werden, da am Integratorausgang 25 dann ein konstanter Wert erscheint und die Umschalter 13 und 20 in ihrer jeweiligen Stellung bleiben.

Der Spannungs-Frequenz-Umsetzer 6 erhält zwei zu integrierende Spannungen, nämlich die invertierte Meßspannung -U1 und die Referenzspannung Uref. Beide Spannungen müssen, wie das hier realisiert ist, umgekehrte Polaritäten aufweisen. Es ist auch möglich, eine negative Referenzspannung dem zweiten Eingang 23 des Umschalters 20 und eine positive Meßspannung dem ersten Eingang 19 des Umschalters 20 zuzuführen.

In Fig. 2 sind die verschiedenen in der Fig. 1 auftretenden Spannungen schematisch skizziert. Die Spannung U2 hat einen sägezahnförmigen Verlauf. Die Ausgangsspannung U3 der Vergleichsschaltung 16 hat einen impulsförmigen Verlauf. Der Impuls tritt während der Zeit tb auf und die Impulspause während der Zeit ta. Der Abstand zwischen den Rückflanken zweier Impulse ist gleich der Periodendauer und proportional der Amplitude der Meßspannung.

Das dem Spannungs-Frequenz-Umsetzer 6 nachgeschaltete Differenzierglied 7 erzeugt eine Spannung U4, die aus den vom Spannungs-Frequenz-Umsetzer 6 gelieferten Impulsen Nadelimpulse erzeugt. In dem elektronisch-optischen-Umsetzer 8 werden dann aus den Nadelimpulsen optische Impulse erzeugt, die in den Lichtwellenleiter 2 eingestrahlt werden.

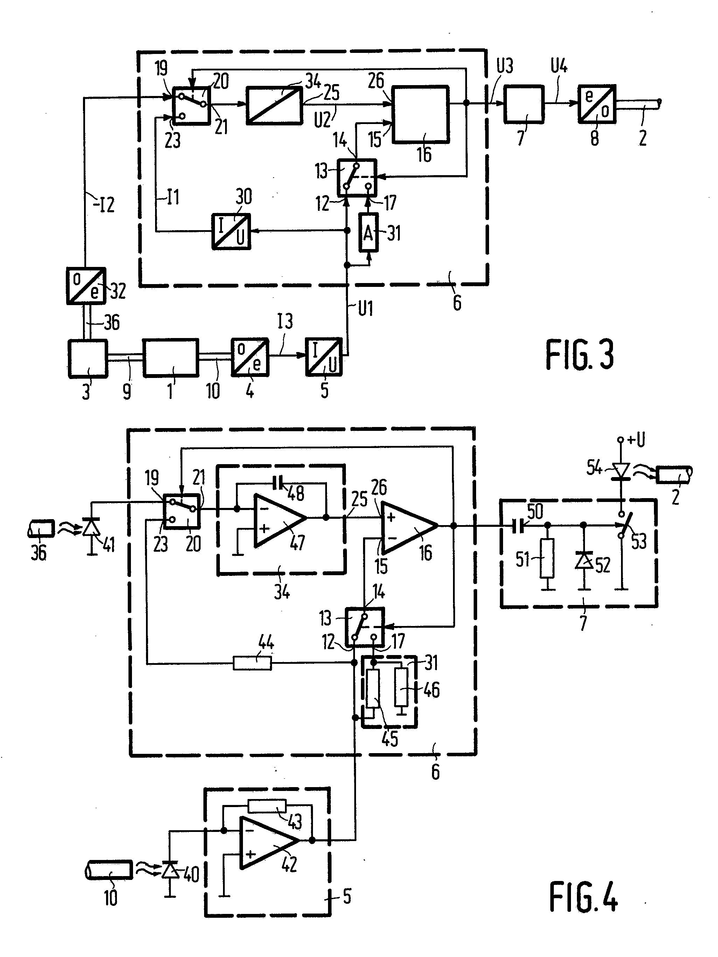

Das in Fig. 3 dargestellte weitere Ausführungsbeispiel der Anordnung zur Übertragung eines Meßsignals des optischen Sensors 1 über den Lichtwellenleiter 2 weist ebenfalls die Sendelichtquelle 3, den optisch-elektronischen-Umsetzer 4, den Strom-Spannungs-Umsetzer 5, den Spannungs-Frequenz-Umsetzer 6, das Differenzierglied 7 und den elektronisch-optischen-Umsetzer 8 auf. Der Spannungs-Frequenz-Umsetzer 6 weist zusätzlich einen Spannungs-Strom-Umsetzer 30 auf, der die Meßspannung U1 in einen Meßstrom I1 umsetzt, der dem zweiten Eingang 23 des Umschalters 20 zugeführt wird. Der zweite Eingang 17 des Umschalters 13 ist mit einem Dämpfungsglied 31 verbunden, das die Meßspannung U1 um den Faktor A abschwächt. Dem ersten Eingang 12 des Umschalters 13 wird die Meßspannung U1 zugeführt und der Ausgang 14 des ersten Umschalters 13 ist mit dem ersten Eingang 15 der Vergleichsschaltung 16 verbunden. Der erste Eingang 19 des Umschalters 20 ist mit einem weiteren optisch-elektronischen-Umsetzer 32 verbunden. Dieser Umsetzer 32 erhält das von der Sendelichtquelle 3 ausgesendete Sendelicht über einen Lichtleiter 36 und setzt dieses in einen elektrischen Strom -I2 um. Die beiden Ströme I1 und -I2 werden abwechselnd in einem invertierenden Integrator 34 integriert, dessen Ausgangsspannung U2 dem zweiten Eingang 26 der Vergleichsschaltung 16 geliefert wird. Die Ausgangsspannung U3 der Vergleichsschaltung 16 wird als Steuerspannung den beiden Umschaltern 13 und 20 und dem Differenzierglied 7 zugeführt, das die differenzierte Spannung U4 dem elektronisch-optischen-Umsetzer 8 liefert.

Die Funktionsweisen der Spannungs-Frequenz-Umsetzer 6 der Fig. 3 und 1 sind identisch. In der ersten Stellung der beiden Umschalter 13 und 20 ergibt sich die folgende Ausgangsspannung U2 des Integrators 34:

$$U2 = A \; U1 + I2 \; K1 \; t, \qquad (6)$$

wobei A die Dämpfungskonstante des Dämpfungsgliedes 31 und K1 die Integrationskonstante des Integrators 34 ist. Die Meßspannung U1 wird aus dem vom optisch-elektronischen-Umsetzer 4 erzeugten Meßstrom I3 mittels des Strom-Spannungs-Umsetzers 5 erzeugt, der proportional der Lichtintensität des optischen Meßsignals ist. Für die Zeit ta, in der die beiden Umschalter 13 und 20 in ihrer ersten Stellung sind, ergibt sich:

$$ta = (I3/I2) \; S1 \; (1 - A)/K1, \qquad (7)$$

wobei $U1 = S1 \; I3$ ist und S1 die Umsetzkonstante des Strom-Spannungs-Umsetzers 5 ist.

Die Ausgangsspannung U2 des Integrators 34 in der zweiten Stellung der beiden Umschalter 13 und 20 ist durch die folgende Gleichung gegeben:

$$U2 = U1 - I1 \; K1 \; t. \qquad (8)$$

für die Zeit tb, in der die beiden Umschalter 13 und 20 in ihrer zweiten Stellung sind, gilt:

$$tb = S2 \; (1 - A)/K1, \qquad (9)$$

wobei $I1 = U1/S2$ ist und S2 die Umsetzkonstante des Spannungs-Strom-Umsetzers 30 ist. Die Summierung der beiden Zeiten ta und tb ergibt die Periodendauer T. Nach Summierung der beiden Gleichungen (7) und (9) ergibt sich:

$$T = (1 - A) \; (S2 + S1 \; I3/I2)/K1. \qquad (10)$$

Aus der Gleichung 10 läßt sich entnehmen, daß die Periodendauer T für einen geringen Meßstrom I3 abhängig von der Dämpfungskonstanten A, der Umsetzkonstanten S2 und der Integrationskonstanten K1 ist. Auch bei diesem Ausführungsbeispiel darf der Meßstrom I3 niemals gleich Null werden.

In Fig. 4 ist ein etwas detaillierteres Ausführungsbeispiel der Fig. 3 dargestellt. Die optisch-elektronischen-Umsetzer 4 und 32 sind jeweils mit Fotodioden 40 und 41 realisiert. Die Fotodioden 40 und 41 setzen jeweils die von Lichtleitern 10 und 36 transportierten optischen Signale in einen elektrischen Strom um.

Die Anode der Fotodiode 40 ist an Masse geschaltet, während die Kathode mit dem invertierenden Eingang eines Verstärkers 42 verbunden ist, dessen nichtinvertierender Eingang an Massepotential geschaltet ist. Der invertierende Eingang des Verstärkers 42 ist mit seinem Ausgang mittels eines Widerstandes 43 rückgekoppelt. Der Verstärker 42 und der Widerstand 43 bilden den Strom-Spannungs-Umsetzer 5.

Die vom Verstärker 42 gelieferte Meßspannung U1 wird über einen Widerstand 44 dem zweiten Eingang 23 des zweiten Umschalters 20, dem ersten Eingang 12 des ersten Umschalters 13 und über einen Widerstand 45 dem zweiten Eingang 17 des ersten Umschalters 13 zugeführt. Der Widerstand 44 ist der Spannungs-Strom-Umsetzer 30. Der Widerstand 45 ist Bestandteil des Dämpfungsgliedes 31, das noch einen an Massepotential geschalteten Widerstand 46 enthält. Der gemeinsame Anschluß der Widerstände 45 und 46 ist an den zweiten Eingang 17 des ersten Umschalters 13 angeschlossen. Wenn die in Fig. 4 dargestellte Anordnung mit einer Versorgungsspannung betrieben wird, bildet das Massepotential eine Aussteuerungsgrenze der Signale. Ein Setzen der Referenzspannung auf Massepotential am zweiten Eingang 17 des Umschalters 13 könnte zu Fehlern führen. Daher wird mittels des Dämpfungsgliedes 31 ein Betreiben an der Aussteuerungsgrenze verhindert.

Der Ausgang 14 des ersten Umschalters 13 ist mit dem invertierenden Eingang 15 eines als Vergleichsschaltung 16 ausgebildeten Verstärkers angeschlossen. Der nichtinvertierende Eingang 26 ist mit dem Ausgang 25 des invertierenden Integrators 34 verbunden. Der Integrator 34 enthält einen Verstärker 47, dessen nichtinvertierender Eingang an Massepotential angeschlossen ist und dessen invertierender Eingang über einen Kondensator 48 mit seinem Ausgang verbunden ist. Der Umschalter 20 liefert dem invertierenden Eingang des Verstärkers 47 das an einem seiner Eingänge 19 oder 23 anliegende Signal. Der Eingang 19 des Umschalters 20 ist mit der Kathode der Fotodiode 41 verbunden, deren Anode an Massepotential angeschlossen ist.

Der Ausgang des Verstärkers 16 ist an das Differenzierglied 7 angeschlossen, welches das Ausgangssignal U3 über einen Kondensator 50 einer Parallelschaltung aus einem an Massepotential angeschlossenen Widerstand 51 und einer Diode 52 zuleitet. Die Anode der Diode 52 ist ebenfalls an Massepotential angeschlossen. Der gemeinsame Anschluß des Kondensators 50, des Widerstandes 51 und der Diode 52 ist an einen Steuereingang eines Schalters 53 angeschlossen. Liegt ein differenzierter Impuls vor, ist der Schalter 53 geschlossen. Der Schalter 53 ist einerseits an Massepotential geschaltet und andererseits mit der Kathode einer lichtemittierenden Diode 54 verbunden, deren Anode an eine Versorgungsspannung +U angeschlossen ist. Die den elektronisch-optischen-Umsetzer 8 darstellende Diode 54 strahlt ein optisches Signal in den Lichtwellenleiter 2 ein.

**Patentansprüche**

1. Spannungs-Frequenz-Umsetzer mit einem ersten Umschalter (13), der in seiner ersten Stellung eine Meßspannung und in seiner zweiten Stellung eine Referenzspannung einem ersten Eingang (15) einer Vergleichsschaltung (16) zuführt, und mit einem zweiten Umschalter (20), der in seiner ersten Stellung ein erstes zu integrierendes Signal und in seiner zweiten Stellung ein zweites zu integrierendes Signal über einen Integrator (22, 34) dem zweiten Eingang (26) der Vergleichsschaltung zuführt, welche von der Meßspannung abhängige Impulse erzeugt und welche die beiden Umschalter in ihre erste Stellung setzt, wenn die vom Integrator gelieferte Spannung gleich der Referenzspannung ist, und in ihre zweite Stellung setzt, wenn der vom Integrator gelieferte Wert gleich der Meßspannung ist,
dadurch gekennzeichent, daß eines der zu integrierenden Signale aus der Meßspannung abgeleitet ist.

2. Spannungs-Frequenz-Umsetzer nach Anspruch 1,
dadurch gekennzeichnet, daß die Referenzspannung gleich dem Massepotential, das erste zu integrierende Signal gleich der invertierten Meßspannung und das zweite zu integrierende Signal gleich einer positiven Bezugsspannung ist.

3. Spannungs-Frequenz-Umsetzer nach Anspruch 1,
dadurch gekennzeichnet, daß das erste zu integrierende Signal gleich einem negativen Bezugsstrom ist und daß ein Spannungs-Strom-Umsetzer (30, 44) die Meßspannung in einen Meßstrom umsetzt, der gleich dem zweiten zu integrierenden Signal ist.

4. Spannungs-Frequenz-Umsetzer nach Anspruch 3,
dadurch gekennzeichnet, daß auch die Referenzspannung aus der Meßspannung abgeleitet ist.

5. Verwendung eines Spannungs-Frequenz-Umsetzers nach einem der vorhergehenden Ansprüche in einer Anordnung zur Übertragung eines Meßsignals eines optischen Sensors (1) über einen Lichtwellenleiter (2), bei der ein optisches Meßsignal in einem optisch-elektronischen-Umsetzer (4) in einen Strom und in einem nachgeordneten Strom-Spannungs-Umsetzer (5) der Strom in die Meßspannung umgesetzt wird und bei der die von dem Spannungs-Frequenz-Umsetzer (6) gelieferten Impulse in einem Differenzierglied (7) differenziert und die differenzierten Impulse mittels eines elektronisch-optischen-Umsetzers (8) in ein optisches Signal umgesetzt werden, welches in den Lichtwellenleiter eingestrahlt wird (Fig. 1).

6. Verwendung eines Spannungs-Frequenz-Umsetzers nach Anspruch 3 oder 4 in einer Anordnung zur Übertragung zweier optischer Meßsignale wenigstens eines optischen Sensors (1) über einen Lichtwellenleiter (2), bei der ein erstes optisches Meßsignal in einem ersten optisch-elektronischen-Umsetzer (4) in einen Strom und in einem nachgeordneten Strom-Spannungs-Umsetzer (5) der Strom in die Meßspannung und ein zweites optisches Meßsignal in einem zweiten optisch-elektronischen-Umsetzer (32) in den Bezugsstrom umgesetzt wird, der das erste zu integrierende Signal bildet, und bei der die von dem Spannungs-Frequenz-Umsetzer (6) gelieferten Impulse in einem Differenzierglied (7) differenziert und die differenzierten Impulse mittels eines elektronisch-optischen-Umsetzers (8) in ein optisches Signal umgesetzt werden, welches in den Lichtwellenleiter eingestrahlt wird (Fig. 3, 4).

FIG.1

FIG.2

FIG. 3

FIG.4